(19) Europäisches Patentamt
European Patent Office
Office européen des brevets

(11) **EP 1 741 806 A1**

(12) **EUROPÄISCHE PATENTANMELDUNG**

(43) Veröffentlichungstag:
**10.01.2007 Patentblatt 2007/02**

(51) Int Cl.:
**C25D 17/00** *(2006.01)* **C25D 17/06** *(2006.01)*
**C25D 21/12** *(2006.01)*

(21) Anmeldenummer: **06002354.6**

(22) Anmeldetag: **04.02.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **08.07.2005 DE 102005031948**

(71) Anmelder: **Höllmüller Maschinenbau GmbH**
**71083 Herrenberg (DE)**

(72) Erfinder:
• **Kosikowski, Thomas**
**90559 Burgthann (DE)**
• **Hübel, Egon**
**90537 Feucht (DE)**

(74) Vertreter: **Ostertag, Ulrich et al**
**Patentanwälte**
**Ostertag & Partner**
**Epplestr. 14**
**70597 Stuttgart (DE)**

(54) **Vorrichtungen und Verfahren zur elektrolytischen Behandlung von Folien von Rolle zu Rolle**

(57) Die Erfindung betrifft die elektrolytische Behandlung von Bändern von Rolle zu Rolle. Bei den Bändern handelt es sich um Kunststoffbänder, die an ihren Oberflächen mit elektrisch niedrig leitfähigen Schichten versehen sind, oder um metallische Bänder mit niedriger elektrischer Leitfähigkeit, und die empfindlich gegen mechanische Beschädigungen an ihren Oberflächen sind. Die elektrische Kontaktierung erfolgt mittels einer metallischen Kontaktwalze 2, 3 an jeder Seite mit je einer elastischen Gegenwalze 5, 4 an der anderen Seite des Bandes. Kontaktbereiche 1 wechseln mit längeren elektrolytischen Bereichen 11 entlang der Durchlaufanlage ab.

Zur individuellen Einstellung der Stromdichte an jedem Ort des elektrolytischen Bereiches enthält dieser Bereich individuelle Anoden mit individuellen Gleichrichtern zur Bildung von individuellen elektrolytischen Zellen. Dadurch werden die elektrischen Spannungsabfälle im wenig leitfähigen Band so kompensiert, dass an jedem Ort des elektrolytischen Bereiches unter den Anoden die vorbestimmte Stromdichte wirksam wird.

Fig. 2

EP 1 741 806 A1

**Beschreibung**

Die Erfindung betrifft die elektrolytische Behandlung von Bändern von Rolle zu Rolle in Durchlaufanlagen. Die Bänder bestehen insbesondere aus einem elektrisch niedrig leitfähigen Werkstoff oder aus elektrisch isolierenden Werkstoffen, die einseitig oder beidseitig mit einer dünnen elektrisch leitfähigen Basisschicht versehen sind. Zur Behandlung werden die Bänder von Rolle zu Rolle mittels Transport- und Kontaktwalzen durch die elektrolytische Anlage in horizontaler oder vertikaler Ausrichtung transportiert.

Bei den elektrisch isolierenden Werkstoffen der Folien handelt es sich in der Praxis bevorzugt um Kunststoffe wie z.B. Polyimid, Polyester, Polyethylen, Polyvinylchlorid oder Epoxid. Auf diesen Werkstoffen sind an der Oberfläche einseitig oder beidseitig die leitfähigen Basisschichten vollflächig laminiert oder aufgedampft bzw. gesputtert. Die Oberflächen der Bänder sind in der Regel sehr empfindlich gegen Beschädigungen. Derartige vollflächige Folien finden als Ausgangsmaterial z.B. in der Leiterplattentechnik für flexible Schaltungen, Innen- und Außenlagen oder SmartCards für die RFID-Technik Verwendung. In diesem Falle besteht die Basisschicht in der Regel aus Kupfer. Die Dicke dieser Schicht beträgt z.B. 0,1 1 $\mu$m bis 0,2 $\mu$m. Bei Bändern, die aus einem elektrisch niedrig leitenden Werkstoff bestehen, handelt es sich zum Beispiel um Edelstahlfolien. Diese Metallfolien können ebenfalls mit einer gesputterten elektrisch leitfähigen Schicht als Haftvermittler versehen sein.

Die Oberflächen der Folien werden enfnreder elektrolytisch metallisiert oder geätzt. Nachfolgend wird die Erfindung nur noch an Beispielen der Galvanisierung beschrieben. Sie gilt jedoch auch für andere kathodische und anodische Prozesse zur Behandlung von Bändern.

Bei einer elektrolytischen Behandlung besteht immer die Forderung nach einer großen Stromdichte, um ein wirtschaftliches Verfahren zu erreichen. In der genannten Leiterplattentechnik sind dies Stromdichten von bis zu 20 A/dm$^2$. Bei der elektrolytischen Behandlung von Metallbändern werden noch wesentlich höhere Stromdichten von bis zu 200 A/dm$^2$ angewendet. Diese Stromdichten haben entsprechend hohe Ströme in den elektrolytisch zu behandelnden Folien zur Folge. So muß bei den elektrisch isolierenden Werkstoffen der Folien der gesamte vom elektrolytischen Prozeß herrührende Strom in der dünnen Basisschicht zu einer Kontakteinrichtung abgeleitet werden. Bei Metallbändern kann auch das Grundmetall zur Stromleitung beitragen. Wenn es sich allerdings um sehr dünne Folien mit einem Grundmetall aus Edelstahl handelt, dann ist dieser Beitrag zur Stromleitung nahezu zu vernachlässigen, weil der spezifische elektrische Widerstand von Edelstahl im Vergleich zu Kupfer ca. 40 mal höher ist. Demzufolge entspricht z.B. die elektrische Leitfähigkeit eines Edelstahlbandes mit der Dicke von 20 $\mu$m einer Kupferschicht mit einer Dicke von ca. 0,5 $\mu$m.

Die dünnen elektrisch leitfähigen Schichten auf Kunststoff oder Edelstahl haben einen hohen Widerstand. Entsprechend hoch sind bei den großen Strömen der elektrische Spannungsabfall und die Verlustleistung in den Schichten.

Eine weitere technische Herausforderung stellt die für elektrolytische Behandlungen erforderliche elektrische Kontakteinrichtung dar. Die Behandlungsströme müssen in die dünnen Basisschichten eingeleitet werden. Dabei treten Kontakt-Übergangswiderstände und hohe Schicht-Stromdichten im unmittelbaren Kontaktbereich auf. Dies kann zu örtlichen Überhitzungen und damit zu einer Beschädigung der Oberflächen der Folien und Kontakte führen.

Zur elektrolytischen Behandlung von Folien mit an der Oberfläche leitfähigen Basisschichten sind Vorrichtungen und Verfahren bekannt. In der Druckschrift DE 100 19 713 A1 wird eine Kontaktierung von elektrolytisch zu behandelndem Gut beschrieben. Das Gut wird von oberen und unteren Walzen transportiert. Zur elektrischen Kontaktierung werden desgleichen obere und untere Walzen verwendet. Diese Walzen sind zur Vermeidung einer elektrischen und/oder mechanischen Beschädigung der Oberflächen des Gutes mit einem elastischen und elektrisch sehr gut leitenden Kontaktwerkstoff versehen. Dieser Werkstoff paßt sich der Oberfläche des Gutes an, ohne dabei das Gut beim Stromfluß zu beschädigen. Die Kontakteinrichtung ist besonders geeignet für die Behandlung von empfindlichen Folien der oben genannten Art. Nachteilig sind jedoch die hohen Kosten für den elastischen und elektrisch leitfähigen Werkstoff, die für jede Kontakteinrichtung aufzuwenden sind.

Die Druckschrift EP 0959 153 A2 beschreibt eine Galvanisieranlage für Leiterplatten, die im Durchlauf durch die Anlage gefördert werden. In kurzen Abständen in Transportrichtung befinden sich außerhalb des Galvanisierbereiches 12 obere und untere Kontaktwalzen 20 A und 20 B aus Metall. Zur Vermeidung einer unerwünschten Metallisierung sind sie mit einer Abblendhaube 22 versehen. In Transportrichtung wiederholen sich mehrere Galvanisierbereiche mit Anoden in Anodenkörben 18, die von einer Badstromquelle mit dem Galvanisierstrom versorgt werden. Zur Vermeidung einer elektrolytisch nicht nutzbaren Länge in Transportrichtung soll der Bereich der Anoden möglichst groß und der übrige Bereich für die Kontakt- und Transporteinrichtungen möglichst klein sein. Bei einem Gut mit einer hochohmigen Basisschicht, wie es bei den oben genannten Folien vorliegt, entsteht in der Folie von Anode zu Anode bei den praktisch anzuwendenden Stromdichten ein hoher Spannungsabfall. Dieser hat zur Folge, dass die Anode, die den größten Abstand zur Kontakteinrichtung aufweist, die kleinste Zellspannung aufweist. Dies hat dort die kleinste Stromdichte zur Folge. Des weiteren erweist sich die elektrische Kontaktierung von Folien zur elektrolytischen Behandlung mit oberen und unteren Kontaktwalzen aus Metall als nachteilig. Die Walzen können nicht so präzise hergestellt und in der aus Kunststoff bestehenden Anlage gelagert werden, wie es nötig ist. Die Oberfläche des Gutes wird folglich nur zum Teil an den Kontakten anliegen. Dadurch besteht die Gefahr der partiellen Stromüberlastung. Als besonders nachteilig erweisen sich jedoch derartig im oder in der Nähe des Elektrolyten und damit in der Nähe des dort bestehenden elektrischen Feldes angeordnete Kontaktwalzen. Ihre allmähliche Metallisierung ist auch bei Verwendung der Hauben 22 nicht zu vermeiden. Die Praxis zeigt, dass die vorgesehenen Maßnahmen dies nicht verhindern können. Bestenfalls kann die Metallisierung der Kontaktwalzen zeitlich verzögert werden. Bei empfindlichen Folien besteht immer die Gefahr, dass die meist partiell beginnende Kontaktmetallisierung Eindrücke in den Oberflächen verursacht. Dies ist nicht nur bei der Leiterplattentechnik unzulässig. Bei der Erfindung gemäß obiger Druckschrift sollen die Dichtwalzen 24 im Bereich I und die Hauben 22 über den Kontaktwalzen die Metallisierung verhindern. Die Praxis zeigt, dass dies durch die vorgeschlagenen Maßnahmen auf Dauer nicht zu erreichen ist. Im Abstand von wenigen Stunden müssen die Kontaktwalzen ausgebaut und entmetallisiert werden. Dies besonders dann, wenn mit wirtschaftlich vertretbar hoher Stromdichte galvanisiert wird.

Einen ähnlichen Aufbau beschreibt die Druckschrift DE 103 42 512 B3. Das elektrolytisch zu behandelnde Band wird durch viele elektrolytische Zellen transportiert, wobei sich jede Anode zwischen Dicht- und Kontaktwalzen befindet. Diese elektrolytischen Zellen sind in Transportrichtung erfindungsgemäß sehr kurz, z.B. 2 cm. Dadurch wird das Problem des Spannungsabfalles in sehr dünnen Basisschichten vermieden, mit dem Nachteil einer sehr großen Anzahl erforderlicher elektrolytischer Zellen.

Jedoch ist auch bei dieser Erfindung das unzulässige Metallisieren der Kontaktwalzen nicht zu vermeiden. Die vorgesehenen Dichtwalzen, Hilfsdichtwalzen und Dichtwände sind erfahrungsgemäß für eine ununterbrochene Produktion nicht ausreichend. Auch wenn der Elektrolyt mittels der Dichtmittel von den Kontaktwalzen getrennt wird, so werden die Kontaktwalzen allein durch die Verschleppung des Elektrolyten am benetzten Band permanent mit Elektrolyt beaufschlagt. Das heißt, die Kontaktierelektrode steht mit dem Elektrolyten in Kontakt. Dadurch hat sie eine, wenn auch kleine Flüssigkeitsverbindung in die elektrolytische Zelle hinein. Infolge der Streufähigkeit des Elektrolyten, insbesondere bei hohen Stromdichten, gelangt auch durch die vorgesehenen Dichtmittel hindurch ein Anteil des in der elektrolytischen Zelle vorhandenen elektrischen Feldes an die Kontaktwalzen. Zusammen mit der Benetzung führt dies allmählich zur Metallisierung der Kontaktwalzen. Gleiches gilt auch für die beschriebenen Kontaktbürsten. Nachteilig ist auch die geringe Länge der Anoden in Transportrichtung im Vergleich zur gesamten Anlagenlänge.

Die Druckschrift DE 694 03 926 T2 beschreibt eine Bandanlage mit vielen Teilanoden im Abstand von der Kontakteinrichtung. Die einzelnen Teilanoden werden mittels Relais eingeschaltet und durch Kunststoffabtrennungen separiert. Die Kontakt fernste Teilanode bildet zusammen mit dem kathodisch gepolten Band die elektrolytische Teilzelle mit der kleinsten Zellspannung und damit mit der kleinsten örtlichen Stromdichte. Ursache ist wieder der elektrische Spannungsabfall im Band. Gleich große Stromdichten in den elektrolytischen Teilzellen sind mit dieser Anordnung nicht zu erzielen.

Aufgabe der vorliegenden Erfindung ist es, eine Durchlaufanlage von Rolle zu Rolle mit hoher Produktionsleistung bei kleiner Anlagenlänge zur elektrolytischen Behandlung von bandförmigem Behandlungsgut, das eine niedrige elektrische Leitfähigkeit aufweist und das an den Oberflächen gegen mechanische Beschädigungen empfindlich ist, vorzuschlagen, die für Verfahren zur vollflächigen elektrolytischen Behandlung der Oberflächen des Bandes geeignet ist.

Gelöst wird diese Aufgabe durch die Vorrichtungen gemäß der Patentansprüche 1 bis 7 und 13 bis 19 sowie durch die Verfahren gemäß der Patentansprüche 8 bis 12 und 20 bis 23.

Erfindungsgemäß erfolgt die elektrische Kontaktierung des mechanisch und elektrisch empfindlichen Bandes durch eine Kontaktwalze an der Oberseite und bei zweiseitiger Behandlung durch eine weitere Kontaktwalze an der Unterseite des Bandes. Diese sind quer zur Transportrichtung mindestens über die Breite des breitesten zu behandelnden Bandes angeordnet. Diese beiden Kontaktwalzen sind in Transportrichtung zueinander versetzt. Die Kontaktwalzen bestehen mindestens an ihrer Oberfläche aus Metall oder einem anderen mechanisch und chemisch stabilen Werkstoff, der elektrisch leitfähig ist. Vorzugsweise bestehen sie aus Edelstahl.

Jeder Kontaktwalze ist eine Gegenwalze zugeordnet. Diese sind an der anderen Seite des Bandes jeweils den Kontaktwalzen gegenüber angeordnet. Die Kontaktwalze und die zugeordnete Gegenwalze bilden ein Kontaktpaar. Die Gegenwalze besteht mindestens im Bereich ihrer Oberflächen aus einem elastischen Werkstoff. Vorzugsweise ist dieser Werkstoff elektrisch nicht leitend. Geeignet sind zum Beispiel Elastomere, Gummi und andere weiche und im Elektrolyten beständige Kunststoffe.

Mindestens eine Walze des Kontaktpaares wird angetrieben und dient zugleich als Transportwalze für das Band. Dieses durchfährt das Kontaktpaar und wird dadurch an der Seite der Kontaktwalze elektrisch kontaktiert. Zwei in Transportrichtung versetzte Kontaktpaare sind am Band spiegelbildlich zueinander angeordnet. Beide Kontaktpaare bilden einen Kontaktbereich.

Durch die Kombination von harter Kontaktwalze und weicher Gegenwalze wird auch dann ein sicherer elektrischer Kontakt quer zur Transportrichtung über das gesamte Band an einer Seite erreicht, wenn die Walzenanordnung mit Toleranzen behaftet ist. Durch die elastische Gegenwalze wird der sichere elektrische Kontakt hergestellt, wobei zugleich das Band mechanisch schonend berührt wird. Das Band erfährt in Abhängigkeit von der Härte der elastischen Gegenwalze eine kleine Umschlingung um die Kontaktwalze entlang der Mantellinie an der Berührungsstelle. Dadurch entstehen zwei eng benachbarte Grenzlinien vom umschlungenen Kontakt zur Bandoberfläche. Insgesamt verringert dies wesentlich den elektrischen Übergangswiderstand Rü der Kontaktierung. Dies hat zur Folge, dass an der Kontaktstelle die elektrische Verlustleistung P und damit die Erwärmung, die nach der Formel $P = I^2 * Rü$ berechnet wird, in gleichem Maße verringert wird. Dies ist besonders bei großen zu übertragenden Strömen I, wie sie bei wirtschaftlich arbeitenden Durchlaufanlage mit hoher Produktionsleistung vorkommen, besonders wichtig.

Eine weitere Erwärmung der Kontaktstelle entsteht in der wenig leitfähigen Schicht des Bandes in Folge einer sehr hohen Schichtstromdichte is . Bei einem Gesamtstrom I von z.B. 50 A, der in Transportrichtung und in die Gegenrichtung in ein 500 mm breites Band zu übertragen ist, das eine leitfähige Anfangsschichtdicke von 0,2 $\mu$m aufweist, tritt eine Schichtstromdichte is auf mit dem Wert

$$is = ( ½ * 50 \text{ A} / 500 \text{ mm}) / 0,0002 \text{ mm} = 250 \text{ A/mm}^2.$$

Aus den beschriebenen Gründen wird der Kontaktbereich erfindungsgemäß mit einer Kühlflüssigkeit gekühlt.

Damit ist diese Art der elektrischen Kontaktierung mittels der Kontaktpaare sehr zuverlässig. Überraschend treten auch bei sehr hohen Stromdichten und entsprechend hohen Strömen keine mechanischen oder elektrischen Beschädigungen des Bandes auf. Ein weiterer Vorteil sind die sehr kostengünstigen Herstellkosten, weil bei derartigen Durchlaufanlagen Walzen aus Metall, Kunststoff und aus elastischen nicht leitenden Werkstoffen weit verbreitet sind und in großer Stückzahl hergestellt werden.

Zur Leistungssteigerung der elektrolytischen Bandanlage wird erfindungsgemäß zwischen zwei Kontaktbereichen ein langer elektrolytischer Bereich eingefügt. Bei elektrisch wenig leitfähigen Bändern und/oder Basisschichten tritt dann das Problem des elektrischen Spannungsabfalles im Band auf. Zur Vermeidung der nach dem Stand der Technik unterschiedlichen Zellspannungen in Folge der Spannungsabfälle wird erfindungsgemäß der elektrolytische Bereich in Teilbereiche aufgeteilt. Jeder Teilbereich zu beiden Seiten des Bandes ist eine elektrolytische Zelle, die von je einem individuellen Gleichrichter mit Badstrom versorgt wird. Dadurch kann in jeder elektrolytischen Zelle unabhängig von den anderen Zellen eine vorbestimmte örtliche Stromdichte entsprechend der örtlichen Schichtdicke des Bandes eingestellt werden. Diese wird unabhängig von den Spannungsabfällen im Band exakt eingehalten. Hierzu dient ein Steuerungs- und Regelungssystem der Bandanlage.

Die Erfindungen werden nachfolgend an Hand der schematischen und nicht maßstäblichen Figuren 1 bis 5 detailliert beschrieben.

Figur 1 zeigt das Grundprinzip der elektrischen Kontaktierung beider Seiten eines elektrolytisch zu behandelnden Bandes.

Figur 2 zeigt ein Prinzip der Anordnung von elektrolytischen Zellen zwischen elektrischen Kontaktierungen.

Figur 3 zeigt ein weiteres Prinzip der Anordnung von elektrolytischen Zellen zwischen elektrischen Kontaktierungen.

Figur 4 zeigt eine vollständige Anordnung von elektrischen Kontakten mit elektrolytischen Zellen als Teil einer Bandanlage.

Figur 5 zeigt das elektrische Ersatzschaltbild des elektrolytischen Bereiches zwischen zwei Kontaktbereichen.

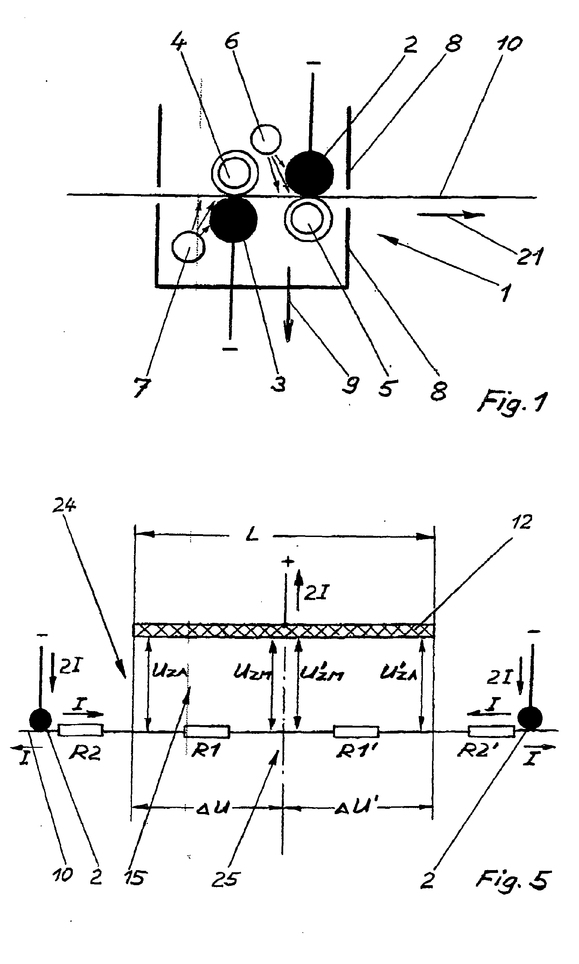

Figur 1 zeigt im Querschnitt einen Kontaktbereich 1 mit der oberen Kontaktwalze 2 und der unteren Kontaktwalze 3. Diese bestehen vorzugsweise aus Metall. Diesen Walzen gegenüber sind eine obere Gegenwalze 4 und eine untere Gegenwalze 5 angeordnet. Die Kontaktwalze und die Gegenwalze bilden das Kontaktpaar. Die Gegenwalze besteht mindestens in ihrem Bereich an der Oberfläche aus einem elastischen Werkstoff. So kann der Kern dieser Walzen z.B. aus einem harten Kunststoff bestehen, der einen weichen Überzug aus einem anderen Werkstoff enthält. Die Walzen 2, 3, 4, 5 erstrecken sich quer zur Transportrichtung über die gesamte Arbeitsbreite. Mindestens eine Walze eines Walzenpaares ist zum Transport des Bandes angetrieben. In der Regel sind obere und untere Walzen angetrieben. Zur Stromübertragung auf die Kontaktwalzen 2, 3 dienen nicht dargestellte Rotationskontakte oder Schleifkontakte. Beim Galvanisieren sind die Kontaktwalzen kathodisch geschaltet. Deshalb besteht auch nicht die Gefahr einer anodischen Auflösung von elektrochemisch unbeständigen Metallen. Somit können auch hoch leitfähige Metalle wie z.B. Kupfer oder Messing verwendet werden. Desgleichen Verbundwerkstoffe aus Metallen.

Wenn die elektrolytischen Zellen eine bevorzugt längere Strecke zwischen zwei Kontaktbereichen aufweisen, dann ist die Summe der Anodenströme hoch. Entsprechend hoch sind die von den Kontaktwalzen auf das Band zu übertragenden Ströme.

Bei hohen Strömen, wie es unten noch ausfühdicher gezeigt wird, besteht die Gefahr der zu großen Erwärmung der Kontaktwalzen 2, 3 und des Bandes 10 im Kontaktbereich 1, insbesondere dann, wenn die elektrisch leitfähige Schicht des Bandes eine kleine Schichtdicke aufweist. Dies kann sowohl zur Beschädigung der Kontakte als auch des Bandes in Folge einer Überhitzung führen. Um dies zu vermeiden, werden die Kontaktbereiche oben und unten mittels einer Kühlflüssigkeit gekühlt. Hierzu dienen Sprührohre 6, 7. Sie sind bevorzugt parallel zu den Kontaktwalzen und quer über die gesamte Arbeitsbreite angeordnet. Die Sprührohre sind bevorzugt so ausgerichtet, dass sowohl die Kontakte als auch das Band 10 von der Kühlflüssigkeit erreicht wird. Die Sprührichtung ist mindestens an der Oberseite des Bandes so ausgebildet, dass die Kühlflüssigkeit, bevorzugt DI Wasser, seitlich abfließen kann. Das Kühlwasser wird in einem Kühlwasser-Auffangbehälter 8 gesammelt und durch einen Kühlwasserablauf 9 einer Rückkühlung zugeführt. Insgesamt erlauben diese Maßnahmen die Anwendung von hohen Stromdichten und Strömen, wenn die dünne Anfangsschicht bereits auf mindestens 1 μm verstärkt worden ist. Zum Beispiel von 10 A/dm$^2$ und Ströme von bis zu 300 A pro Kontaktwalze bei einer Bandbreite von 500 mm.

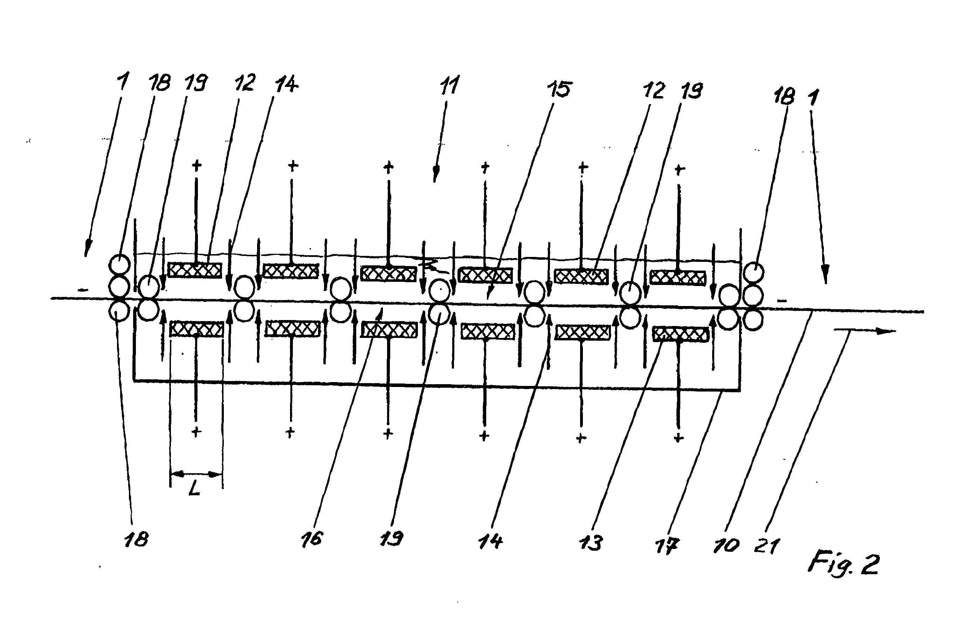

**Die Figur 2** zeigt den elektrolytischen Bereich 11, so wie er zwischen den Kontaktbereichen 1 angeordnet ist. Zum Galvanisieren befinden sich in diesem Bereich als Beispiel sechs obere und sechs untere elektrolytische Zellen mit den anodischen Elektroden und dem kathodischen Band. Nachfolgend werden die Elektroden für das hier beschriebene Galvanisieren mit Anoden bezeichnet. Somit sind sechs obere Anoden 12 und sechs untere Anoden 13 zur beidseitigen elektrolytischen Behandlung des Bandes 10 dargestellt. Dabei kann es sich um lösliche oder unlösliche Anoden handeln. Jede der Anoden wird von einem eigenen unabhängigen Gleichrichter mit Badstrom versorgt. Die Gleichrichter sind nicht dargestellt. Der Pluspol eines jeden Gleichrichters ist mit der zugehörigen Anode verbunden. Die Minuspole der Gleichrichter sind miteinander verbunden. Sie sind gemeinsam an den Kontaktwalzen 2, 3 angeschlossen. Die Badstromquellen werden allgemein als Gleichrichter bezeichnet. Beim Badstrom kann es sich um Gleichstrom oder unipolaren Pulsstrom handeln. Desgleichen auch um bipolaren Pulsstrom. Auch bei diesem Strom ist eine Polarität überwiegend. Beim Galvanisieren ist dies die kathodische Polarität, bezogen auf das zu behandelnde Band.

Die einzelnen Anoden bilden mit dem kathodisch gepolten Band individuelle obere elektrolytische Zellen 15, und untere elektrolytische Zellen 16. Zu beiden Seiten der Anoden 12, 13 wird Elektrolyt mittels der symbolisch dargestellten Sprüheinrichtungen 14 in die elektrolytischen Zellen 15, 16 eingeleitet und an das Band 10 angeströmt. Diese Einrichtungen erstrecken sich ebenso wie die Anoden quer zur Transportrichtung über die gesamte Breite des Arbeitsbehälters. Die aus Kunststoff bestehenden Sprüheinrichtungen 14 dienen zugleich zur elektrischen Trennung und Isolation von benachbarten Anoden. Der Elektrolyt wird im Arbeitsbehälter 17 mindestens so hoch angestaut, dass die oberen Anoden 12 vom Elektrolyt bedeckt sind. Dies erfordert entsprechend hohe Dichtwalzen 18 am Einlauf und am Auslauf des Arbeitsbehälters 17.

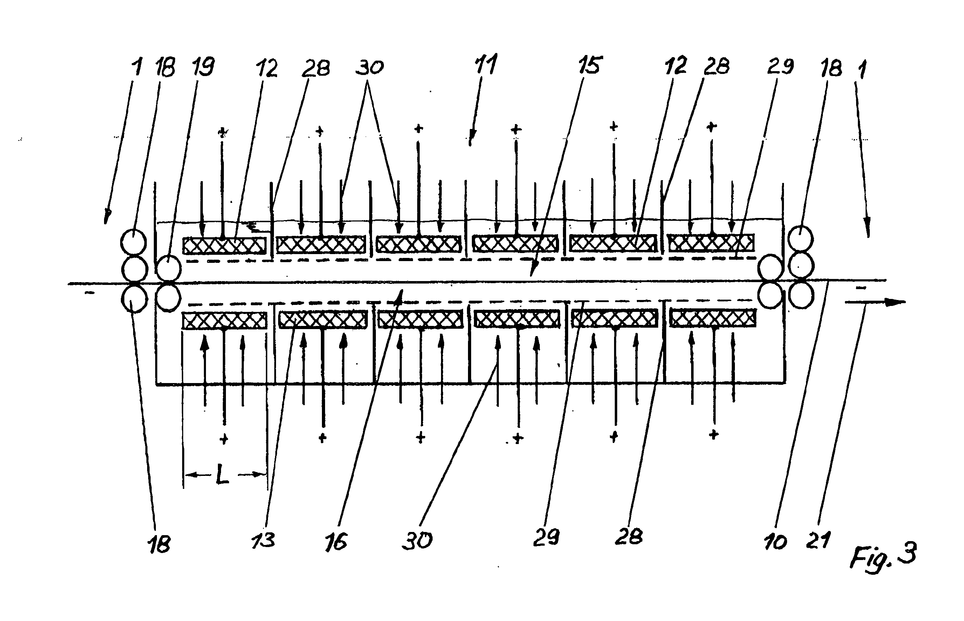

Zwischen den Anoden 12, 13 sind jeweils Stützwalzen 19 angeordnet. Sie haben die Aufgabe, das Band 10 in der Mitte zwischen den oberen elektrolytischen Zellen 15 und den unteren elektrolytischen Zellen 16 zu führen. Dies ist besonders bei einem kleinen Anoden-/Kathodenabstand wichtig, um Beschädigungen des Bandes durch Berührung von stationären Konstruktionselementen in den elektrolytischen Zellen zu vermeiden. Die Stützwalzen 19 sind angetrieben, so dass es zu keiner schleifenden Berührung des Bandes kommt. Bei längeren Anoden in Transportrichtung kann vor den Anoden zusätzlich je ein Führungselement angeordnet werden, wie es nachstehend an Hand der Figur 3 beschrieben wird.

Bei einer weiteren Ausführung der Erfindung wird auf die Stützwalzen 19 verzichtet. Dies zeigt die **Figur 3**. Das zu transportierende Band wird mittels Führungselementen 29 zu beiden Seiten so geführt, das es in den elektrolytischen Zellen des Bereiches 11 zu keinen elektrischen Kurzschlüssen zwischen dem Band 10 und den Anoden 12, 13 kommen kann. Die Führungselemente 29 bestehen aus einem elektrisch isolierenden und für Ionen durchlässigen Werkstoff. Zur elektrischen Trennung der benachbarten Anoden sind oben und unten dünne Isolierwände 28 aus Kunststoff eingefügt. Dadurch ergibt sich eine besonders große Länge L der Anoden in Transportrichtung bezogen auf die verfügbare Gesamtlänge des elektrolytischen Bereiches 11. Die Isolierwände 28 reichen zur Vermeidung von Stolperkanten jeweils nur bis zu den Führungselementen 29.

Der für den elektrolytischen Prozeß erforderliche Elektrolytaustausch in den elektrolytischen Zellen erfolgt durch Strömungselemente 30. Sie leiten Elektrolyt durch die unlöslichen Anoden und durch die Führungselemente hindurch zum zu behandelnden Band.

Eine weitere nicht dargestellte Möglichkeit zur Elektrolyteinleitung in die elektrolytischen Zellen bieten die Isolierwände 28. Bei entsprechend dickerer Ausführung und mit inneren Kanälen erfüllen sie zugleich die Funktion von Sprührohren.

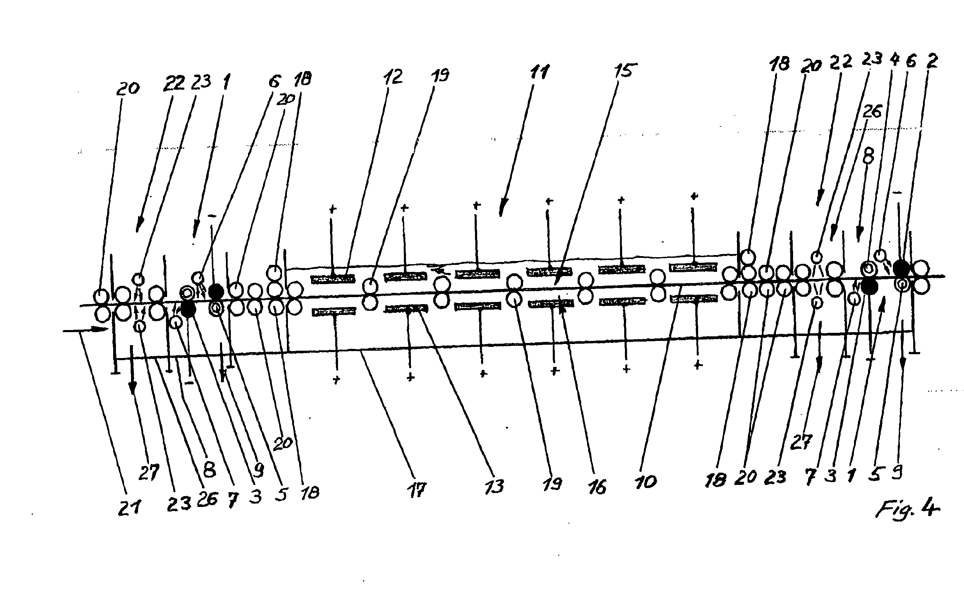

**Figur 4** zeigt die komplette Anordnung von zwei Kontaktbereichen 1 mit dazwischen liegendem elektrolytischen Bereich 11. Zu beiden Seiten der Dichtwalzen 18 des Arbeitsbehälters 17 befinden sich Abquetschwalzen 20. Besonders am Auslauf des Arbeitsbehälters in Transportrichtung 21 gesehen sorgen diese Abquetschwalzen 20 für eine niedrige Verschleppung von Elektrolyt in den nachfolgenden Kontakbereich 1. Eine völlige Unterbindung der Verschleppung ist mit derartigen Abquetschwalzen nicht möglich. Insbesondere bei Bändern, die in Transportrichtung keine Lücken aufweisen, führt die verbleibende Benetzung des Bandes immer zur Restmengenverschleppung. Damit in den nachfolgenden Kontaktbereich 1 nahezu keine Elektrolytreste eingebracht werden, ist vor diesem Bereich 1 ein mindestens einstufiger Spülbereich 22 mit oberen und unteren Sprühstöcken 23 zum Ansprühen und Spülen des Bandes mit Spülflüssigkeit, vorzugsweise DI Wasser, angeordnet. Das Spülwasser wird im Spülwasser-Auffangbehälter 26 gesammelt und durch den Spülwasserablauf 27 einer Regenerierung zugeführt.

Das Spülen kann auch in mindestens einem Spülbad als Stehende Welle erfolgen. Hierzu wird die Spülflüssigkeit mittels Stauwalzen so hoch angestaut, dass das Band die Spülflüssigkeit durchfährt und dabei gespült wird. Auch Kombinationen von Spülarten sind möglich.

Durch die Abquetschwalzen 20 und die Spülung in dem Spülbereich 22 gelangen nahezu keine Elektrolytreste an die Kontaktwalzen. Stets verbleibende Reste sind jedoch so hoch verdünnt, dass eine elektrolytische Abscheidung von Metall auf den Kontaktwalzen 2, 3 nicht stattfinden kann. Dies auch dann, wenn aus den benachbarten elektrolytischen Bereichen 11 ein abgeschwächtes elektrisches Feld bis zu den von den elektrolytischen Zellen entfernt angeordneten Kontaktwalzen durchgreift. Dieser Durchgriff erfolgt durch die immer vorhandenen mechanisch bedingten Leckagen und in Folge der Benetzung des Bandes. Durch die hohe Elektrolytverdünnung und die entfernte Anordnung der Kontaktwalzen vom elektrolytischen Bereich 11 wird die Gefahr einer Metallisierung der Kontaktwalzen sicher vermieden. Die Menge der verschleppten Elektrolytmenge aus dem Arbeitsbehälter 17 in den Spülbereich 22 ist u.a. auch von der Transportgeschwindigkeit des Bandes abhängig. Bei langsamer Geschwindigkeit genügt eine kleinere Spülwassermenge pro Zeit, um eine bestimmte Verdünnung zu erreichen. Deshalb ist bevorzugt der Spülwasserdurchfluß in Abhängigkeit von der Transportgeschwindigkeit einstellbar.

Die elektrolytische Bandanlage gemäß der Figur 4 setzt sich in Transportrichtung fort. Auf jeden Kontaktbereich 1 folgt ein elektrolytischer Bereich 11 mit mehreren unabhängig mit Badstrom versorgten Anoden 12, 13 gefolgt vom Spülbereich 22 und dem nächsten Kontaktbereich 1. Die Anzahl der elektrolytischen Bereiche 11 wird u.a. von der geforderten Anlagenleistung und der Art des abzuscheidenden Metalles bestimmt. Bei einem Kupferelektrolyt auf Basis von Schwefelsäure wird z.B. bei einer Stromdichte von 5 A/dm$^2$ in einer Minute eine Schicht von ca. 1 $\mu$m Dicke abgeschieden. Leiterfolien aus z.B. Polyimid mit gesputterten Basisschichten aus Kupfer mit einer Dicke von 0,1 $\mu$m bis 0,2 $\mu$m werden in der Praxis vollflächig auf z.B. 10 $\mu$m oder 20 $\mu$m elektrolytisch verstärkt. Die Schichtdicke des Kupfers nimmt in Transportrichtung von elektrolytischer Zelle zu elektrolytischer Zelle zu. Bereits nach einer kurzen Behandlungsstrecke von z.B. einem Meter hat sich die Anfangsschichtdicke mehr als verdoppelt. Entsprechend nimmt auch die Strombelastbarkeit des Bandes zu. Deshalb wird am Anfang der erfindungsgemäßen Bandanlage mit einer kleinen Stromdichte zu galvanisieren begonnen. Weil jede Anode in der Stromdichte eingestellt werden kann, läßt sich in der Bandanlage eine sehr feinstufige Rampe für die ansteigende Stromdichte von Anode zu Anode bzw. von elektrolytischer Zelle zu elektrolytischer Zelle einstellen. Dadurch wird eine elektrische Überlastung der empfindlichen Sputterschichten und damit eine diesbezügliche Beschädigung der Bandoberflächen sicher vermieden. Gleichzeitig wird die Stromdichte an die Belastbarkeitszunahme in Folge der Schichtdickenzunahme von Zelle zu Zelle optimal angepaßt. Dies bedeutet zugleich eine Optimierung der Anlagenlänge bezogen auf den Durchsatz.

Die Steigung der Stromdichterampe ist auch abhängig von der Transportgeschwindigkeit. Bei langsamer Geschwindigkeit kann sie steil sein, weil die Schichtdickenzunahme in Folge einer längeren Behandlungszeit pro Anode 12, 13 größer ist, als bei hoher Geschwindigkeit. Auch hierfür ist die Aufteilung des elektrolytischen Bereiches 11 in viele elektrolytische Zellen sehr vorteilhaft.

Nach Erreichen einer Mindestschichtstärke von z.B. 3 $\mu$m könnte aus Gründen der Strombelastbarkeit des Bandes eine so hohe Stromdichte gewählt werden, dass andere anlagentechnische oder verfahrenstechnische Grenzen überschritten werden. Bei Erreichen dieser Grenze werden alle nachfolgenden elektrolytischen Zellen 15, 16 mit der gleich hohen Stromdichte von z.B. 10 A / dm$^2$ betrieben.

Die beschriebene Anlage ist besonders zur vollflächigen elektrolytischen Behandlung von Bändern von Rolle zu Rolle vorgesehen. Bei den Bändern handelt es sich z.B. um Leiterfolien der Leiterplattentechnik oder um dünne Metallbänder, wie z.B. Stahlbänder oder Edelstahlbänder. Grundsätzlich lassen sich mit dem erfindungsgemäßen Verfahren und den Vorrichtungen auch kurze Abschnitte behandeln. In diesem Falle müssen die Längen der einzelnen Bereiche 1, 11, 22 insbesondere des elektrolytischen Bereiches entsprechend der Länge der Abschnitte gekürzt werden. Dies ist nötig, um in jedem Falle eine kathodische Kontaktierung der Abschnitte beim Transport durch die Anlage sicher zu stellen.

Ein Beispiel aus der Praxis zeigt die Wirksamkeit der Aufteilung des elektrolytischen Bereiches 11 in mehrere unabhängige elektrolytische Zellen zwischen zwei Kontaktbereichen mit folgenden Daten:

| | |
|---|---|
| Länge des elektrolytischen Bereiches | L = 1,2 m |
| Breite des Bandes | b = 600 mm |
| Dicke der Basisschicht an einer Seite | d = 0,2 $\mu$m |
| Stromdichte | i = 6 A/dm$^2$ |
| Zellspannung | Uz = 3 V |
| Spezifischer Widerstand des gesputterten Kupfers | p = 0,02 $\Omega$mm$^2$/m |
| Querschnitt Q = b * d = 600 mm * 0,0002 mm | Q = 0,12 mm$^2$ |

Daraus ergibt sich gemäß der **Figur 5**:
Elektrischer Widerstand R1 des Bandes zu Beginn der elektrolytischen Behandlung von der Mitte des elektrolytischen Bereiches in Richtung zu den Kontaktbereichen.

$$R1 = (\rho * \tfrac{1}{2}L) / \text{Querschnitt} = (0,02\ \Omega mm^2/m * \tfrac{1}{2} * 1,2\ m) / 0,12\ mm^2 = 0,1\ \Omega$$

Der Galvanisierstrom I fließt von der Mitte des elektrolytischen Bereiches 11 gesehen nahezu symmetrisch zu den beiden benachbarten Kontaktbereichen 1. Deshalb ist hier der halbe elektrolytische Bereich mit der Länge ½L zu betrachten, weil die Anordnung symmetrisch ist. Die Galvanisierströme der hier nicht unterbrochenen Anode 12 konzentrieren sich nicht auf die Mitte der Anode 12, sondern sie verteilen sich über die gesamte Länge und Breite der elektrolytischen Zelle möglichst homogen. In Transportrichtung wird demnach nicht der gesamte Widerstand R1 des Bandes von dem gesamten Wert des Galvanisierstromes I durchflossen. Bei der Berechnung des Spannungsabfalles am Widerstand R1 ist daher dessen Wert zu halbieren.
Der Galvanisierstrom I eines halben elektrolytischen Bereiches beträgt

$$I = i * \text{Fläche} = i * \tfrac{1}{2}\ L * b$$

$$I = 6\ A / dm^2 * 6\ dm * 6\ dm = 216\ A$$

Damit beträgt der Spannungsabfall ΔU im Band in dem halben elektrolytischen Bereich

$$\Delta U = I \times \tfrac{1}{2}\ R1 = 216\ A * \tfrac{1}{2}\ 0,1\ \Omega = 10,8\ V$$

Dieser Spannungsunterschied würde zu Beginn der elektrolytischen Behandlung einer gesputterten Kupferschicht mit der Dicke von 0,2 μm zwischen dem Anfangsbereich 24 und dem Mittenbereich 25 eines elektrolytischen Bereiches 11 auftreten, wenn die elektrolytische Zelle von einem Gleichrichter mit Strom gespeist wird.
Bei einer vom Gleichrichter vorgegebenen Zellspannung UzA am Anfang des elektrolytischen Bereiches in Höhe der erforderlichen Zellspannung von 3 V würde sich der größte Teil des Stromes I auf den Anfangsbereich 24 konzentrieren. Im Mittenbereich 25 wäre die Zellspannung UZM nahezu 0 Volt. Dieser Bereich trägt damit nicht zur elektrolytischen Behandlung bei.
Nach dem Stand der Technik wird dieses Problem gelöst durch Anwendung einer sehr kleinen Stromdichte und durch kürzere elektrolytische Bereiche zwischen zwei Kontaktbereichen, die die Anlage wesentlich verlängern. Beides verringert die Wirtschaftlichkeit einer elektrolytischen Anlage ganz erheblich.
Im Vergleich hierzu ist die Länge L der Anode 12 der erfindungsgemäßen Anlage als Beispiel aus der Praxis gemäß der Figur 2 mit 150 mm anzunehmen.
Auf dieser Länge beträgt der elektrische Widerstand R im Band ¼ R1. Weil wieder der Widerstand zu halbieren ist, beträgt der zu betrachtende Wert

$$R = \tfrac{1}{4} * \tfrac{1}{2} * 0,1\ \Omega = 0,0125\ \Omega.$$

Damit beträgt im Band der Spannungsabfall ΔU im Bereich der ersten Anode, d.h in der ersten elektrolytischen Zelle einer Durchlaufanlage vom Anoden-Anfangsbereich bis zum Anoden-Endbereich:

$$\Delta U = I * R = 216\ A * 0,0125\ \Omega = 2,7\ V.$$

In der zweiten elektrolytischen Zelle beträgt dieser Spannungsabfall ΔU nur noch 2/3 des Wertes der ersten Zelle, weil in diesem Bereich nur 2/3 des Stromes fließt. Dies sind demnach nur noch

$$\Delta U = 2/3 * 2,7 \text{ V} = 1,8 \text{ Volt.}$$

In der dritten elektrolytischen Zelle 11 beträgt dieser Spannungsabfall ΔU nur noch 1/3 des Wertes der ersten Zelle, weil in diesem Bereich nur 1/3 des Stromes fließt. Dies sind demnach nur noch

$$\Delta U = 1/3 * 2,7 \text{ V} = 0,9 \text{ Volt.}$$

Zum Vergleich mit dem errechneten Spannungsunterschied von 10,8 V nach dem Stand der Technik ist hier der Mittelwert der Spannungunterschiede ΔU im Bereich der drei elektrolytischen Zellen zu bilden. Dies ist

$$\Delta U = (2,7 \text{ V} + 1,8 \text{ V} + 0,9 \text{ V}) / 3 = 1,8 \text{ V}$$

Dies bedeutet eine sechsfache Verbesserung im Vergleich zum Stand der Technik.

Durch die Möglichkeit der Anpassung der Gleichrichterströme von elektrolytischer Zelle zu Zelle, kann der Spannungsabfall ΔU im Band vom Anoden-Anfangsbereich bis zum Anoden-Endbereich jeder Zelle so gewählt werden, dass ein maximal vorbestimmter Unterschied der Stromdichte nicht überschritten wird. Dies ermöglichen die erfindungsgemäß individuellen Gleichrichter der elektrolytischen Zellen mit den jeweiligen Anoden 12, 13 zwischen den zugehörigen Kontaktbereichen 1.

Die Gegenwalze 4, 5 kann insbesondere bei niedrigen zu übertragenden Strömen mindestens im Bereich ihrer Oberfläche auch aus einem elastischen Werkstoff, der elektrisch hoch leitfähig und gegen den Elektrolyten beständig ist, bestehen. In diesem Falle kann die Gegenwalze als Kontaktwalze zur Kontaktierung der anderen Seite des Bandes herangezogen werden. Dadurch ist ein zweites zum Band spiegelbildlich angeordnetes Kontaktpaar eines Kontaktbereiches 1 nicht erforderlich, was zur Verringerung der Anlagenlänge beiträgt.

**Bezugszeichenliste**

| | |
|---|---|
| 1 | Kontaktbereich |
| 2 | Obere Kontaktwalze |
| 3 | Untere Kontaktwalze |
| 4 | Obere Gegenwalze |
| 5 | Untere Gegenwalze |
| 6 | Oberes Sprührohr |
| 7 | Unteres Sprührohr |
| 8 | Kühlwasser-Auffangbehälter |
| 9 | Kühlwasserablauf |
| 10 | Band, Folie, Behandlungsgut |
| 11 | Elektrolytischer Bereich |
| 12 | Obere Anode |
| 13 | Untere Anode |
| 14 | Sprüheinrichtung |
| 15 | Obere elektrolytische Zelle |
| 16 | Untere elektrolytische Zelle |
| 17 | Arbeitsbehälter |
| 18 | Dichtwalzen |
| 19 | Stützwalzen |
| 20 | Abquetschwalzen |
| 21 | Transportrichtung |

22    Spülbereich
23    Sprühstock
24    Anfangsbereich
25    Mittenbereich
26    Spülwasser-Auffangbehälter
27    Spülwasserablauf
28    Isolierwand
29    Führungselement
30    Strömungselement

**Patentansprüche**

1.  Vorrichtung zur elektrolytischen Behandlung von bandförmigem Behandlungsgut, das mindestens an der Oberfläche elektrisch leitend ist, von Rolle zu Rolle in Durchlaufanlagen mit walzenförmigen Transport- und Kontaktmitteln, die außerhalb der elektrolytischen Zellen quer zur Transportrichtung über die gesamte Arbeitsbreite angeordnet sind, **gekennzeichnet durch** mindestens eine Kontaktwalze (2, 3) aus Metall an mindestens einer Seite des Bandes (10) und eine Gegenwalze (4, 5) an der jeweils gegenüber liegenden Seite des Bandes als Kontaktpaar, wobei die Gegenwalze mindestens im Bereich ihrer Oberfläche aus einem elastischen Werkstoff besteht.

2.  Vorrichtung nach Anspruch 1, **gekennzeichnet durch** einen Kontaktbereich 1, bestehend aus zwei in Transportrichtung hintereinander angeordneten Kontaktpaaren mit spiegelbildlicher Anordnung zum Band.

3.  Vorrichtung nach einem der Ansprüche 1 und 2, **gekennzeichnet durch** Kühlflüssigkeits-Sprührohre 6, 7, die quer zur Transportrichtung über die gesamte Arbeitsbreite und parallel zu den Kontaktwalzen im Kontaktbereich so angeordnet sind, dass die Kontaktwalzen und das Band von der Kühlflüssigkeit erreicht werden.

4.  Vorrichtung nach einem der Ansprüche 1 bis 3, **gekennzeichnet durch** einen Kühlwasser-Auffangbehälter (8) im Kontaktbereich zum Sammeln und Ableiten der Kühlflüssigkeit.

5.  Vorrichtung nach einem der Ansprüche 1 bis 4, **gekennzeichnet durch** mindestens einen Spülbereich (22) vor dem Kontaktbereich (1), bestehend aus Sprühstöcken (23) an beiden Seiten des Bandes quer zur Transportrichtung über die gesamte Arbeitsbreite und parallel zu den Transportwalzen oder bestehend aus einer Stehenden Welle.

6.  Vorrichtung nach einem der Ansprüche 1 bis 5, **gekennzeichnet durch** eine Regenerierungseinheit zur Wiederverwendung der Spülwässer aus dem Spülbereich (22).

7.  Vorrichtung nach einem der Ansprüche 1 bis 6, **gekennzeichnet durch** Gegenwalzen, die zur elektrischen Kontaktierung des Bandes mindestens im Bereich ihrer Oberflächen aus einem elastischen und elektrisch hoch leitfähigen Werkstoff bestehen.

8.  Verfahren zur elektrolytischen Behandlung von bandförmigem Behandlungsgut, das mindestens an der Oberfläche elektrisch leitend ist, von Rolle zu Rolle in Durchlaufanlagen mit walzenförmigen Transport- und Kontaktmitteln, die außerhalb der elektrolytischen Zellen quer zur Transportrichtung über die gesamte Arbeitsbreite angeordnet sind, zur Anwendung der Vorrichtung gemäß der Ansprüche 1 bis 7, **dadurch gekennzeichnet, dass** zur elektrischen Kontaktierung das zu behandelnde Band im Kontaktbereich (1) mittels einer mindestens im Bereich ihrer Oberfläche elastische Gegenwalze (4, 5) an eine an der gegenüberliegenden Seite des Bandes angeordnete Kontaktwalze (2, 3), als Kontaktpaar so angedrückt wird, dass sich ein kleiner Umschlingungswinkel des Bandes um die Kontaktwalze bildet, der den Kontaktübergangswiderstand zur Oberfläche des Bandes verringert.

9.  Verfahren nach Anspruch 8, **dadurch gekennzeichnet, dass** durch eine in Transportrichtung hintereinander befindliche und spiegelbildliche Anordnung von Kontaktpaaren zum Band die Oberseite und die Unterseite desselben elektrisch kontaktiert werden.

10. Verfahren nach den Ansprüchen 8 bis 9, **dadurch gekennzeichnet, dass** mittels einer Kühlflüssigkeit aus Sprührohren (6, 7) die Kontaktwalzen und das Behandlungsgut im Kontaktbereich (1) gekühlt werden.

11. Verfahren nach einem der Ansprüche 8 bis 10, **dadurch gekennzeichnet, dass** das Band vor dem Kontaktbereich

9

(1) in einem Spülbereich (22) mittels einer Stehenden Welle gespült wird.

12. Verfahren nach einem der Ansprüche 8 bis 11, **dadurch gekennzeichnet, dass** das Band vor dem Kontaktbereich (1) in einem Spülbereich (22) mittels Sprühstöcken (23) angesprüht und gespült wird.

13. Vorrichtung zur elektrolytischen Behandlung von bandförmigem Behandlungsgut, das mindestens an der Oberfläche elektrisch leitend ist, von Rolle zu Rolle in Durchlaufanlagen mit walzenförmigen Transport- und Kontaktmitteln, die außerhalb der elektrolytischen Zellen quer zur Transportrichtung über die gesamte Arbeitsbreite angeordnet sind, **gekennzeichnet durch** einen elektrolytischen Bereich (11) zwischen zwei Kontaktbereichen (1), der in individuelle elektrolytische Zellen (15, 16) aufgeteilt ist, wobei jede Anode (12, 13) der Zellen von einem individuellen Gleichrichter zur Einstellung einer individuellen Stromdichte gespeist wird.

14. Vorrichtung nach Anspruch 13, **gekennzeichnet durch** elektrisch isolierende Trennmittel (14, 28) zwischen den Anoden (12, 13) jeder Seite.

15. Vorrichtung nach einem der Ansprüche 13 und 14, **gekennzeichnet durch** eine Elektrolyteinleitung **durch** die unlöslichen Anoden hindurch in die elektrolytischen Zellen mittels Strömungselementen (30).

16. Vorrichtung nach einem der Ansprüche 13 bis 15, **gekennzeichnet durch** Sprüheinrichtungen (14) oder **durch** Isolierwände (28) als isolierende Trennmittel zwischen jeder individuellen Anode.

17. Vorrichtung nach einem der Ansprüche 13 bis 16, **gekennzeichnet durch** Stützwalzen (19) oder Führungselemente (29) zur Führung des Bandes in den elektrolytischen Zellen.

18. Vorrichtung nach einem der Ansprüche 13 bis 17, **gekennzeichnet durch** Sprüheinrichtungen (14) für den Elektrolyten vor und nach jeder Stützwalze, oder **durch** Sprühmittel in der Isolierwand (28) zwischen den Anoden.

19. Vorrichtung nach einem der Ansprüche 13 bis 18, **gekennzeichnet durch** Dichtwalzen (18) und Abquetschwalzen (20) vor und nach jedem Arbeitsbehälter (17).

20. Verfahren zur elektrolytischen Behandlung von bandförmigem Behandlungsgut, das mindestens an der Oberfläche elektrisch leitend ist, von Rolle zu Rolle in Durchlaufanlagen mit walzenförmigen Transport- und Kontaktmitteln, die außerhalb der elektrolytischen Zellen quer zur Transportrichtung über die gesamte Arbeitsbreite angeordnet sind, zur Anwendung der Vorrichtung gemäß der Ansprüche 13 bis 19, **dadurch gekennzeichnet, dass** durch individuelle Anoden der elektrolytischen Zellen eines elektrolytischen Bereiches (11) zwischen zwei Kontaktbereichen (1) mit ihren individuellen Gleichrichtern die örtlichen Stromdichten in jeder elektrolytischen Zelle an die örtlichen Schichtdicken der zu behandelnden Oberflächen angepaßt werden können.

21. Verfahren nach Anspruch 20, **dadurch gekennzeichnet, dass** zumindest am Anfang der elektrolytischen Behandlung die wirksame Stromdichte in Transportrichtung von elektrolytischer Zelle zu elektrolytischer Zelle gesteigert wird.

22. Verfahren nach einem der Ansprüche 20 bis 21, **dadurch gekennzeichnet, dass** zur elektrolytischen Behandlung bipolarer oder unipolarer Pulsstrom oder Gleichstrom verwendet wird.

23. Verfahren nach einem der Ansprüche 20 bis 22, **dadurch gekennzeichnet, dass** das Band (10) in den elektrolytischen Zellen von Sprüheinrichtungen mit Elektrolyt angeströmt wird.

EP 1 741 806 A1

Fig. 1

Fig. 5

11

Fig. 2

EP 1 741 806 A1

EP 1 741 806 A1

Fig. 3

13

EP 1 741 806 A1

Fig. 4

14

**Europäisches Patentamt**

**EUROPÄISCHER RECHERCHENBERICHT**

Nummer der Anmeldung

EP 06 00 2354

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 3 264 198 A (WELLS ARTHUR FOREST) 2. August 1966 (1966-08-02) * das ganze Dokument * ----- | 1,13,20 | INV. C25D17/00 C25D17/06 C25D21/12 |
| X | WO 92/18669 A (SIEMENS AKTIENGESELLSCHAFT) 29. Oktober 1992 (1992-10-29) * Seite 11, Zeile 20 - Seite 12, Zeile 11 * * Ansprüche 1-8,12-16 * ----- | 1 | |
| X | DE 43 26 780 A1 (KLEIN, ROLAND, 42281 WUPPERTAL, DE) 16. Februar 1995 (1995-02-16) * Spalte 4, Zeilen 23-45 * * Anspruch 1 * ----- | 1 | |
| X | US 2 742 417 A (SHANLEY JAMES J) 17. April 1956 (1956-04-17) * Spalte 2, Zeile 57 - Spalte 3, Zeile 7 * ----- | 1,13 | |
| X | WO 97/22737 A (CFC, INC) 26. Juni 1997 (1997-06-26) * Seite 4, Zeilen 19-25 * | 13 | RECHERCHIERTE SACHGEBIETE (IPC) C25D H05K |
| Y | * Seite 3, Zeile 14 - Seite 4, Zeile 18 * ----- | 1 | |
| Y | GB 06859 A A.D. 1914 (FERDINAND ARTUR HERRMANN) 17. Juni 1915 (1915-06-17) * Seite 3, Zeile 57 - Seite 4, Zeile 23 * * Abbildungen 5,6 * ----- | 1 | |
| X | EP 0 608 616 A (EBARA-UDYLITE CO, LTD) 3. August 1994 (1994-08-03) * Ansprüche 1-5 * ----- | 13,14 | |

Der vorliegende Recherchenbericht wurde für alle Patentansprüche erstellt

| Recherchenort | Abschlußdatum der Recherche | Prüfer |
|---|---|---|
| München | 27. September 2006 | Haering, Christian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
......................................................
& : Mitglied der gleichen Patentfamilie, übereinstimmendes Dokument

EPO FORM 1503 03.82 (P04C03)

**Europäisches**
**Patentamt**

Nummer der Anmeldung

EP 06 00 2354

---

## GEBÜHRENPFLICHTIGE PATENTANSPRÜCHE

Die vorliegende europäische Patentanmeldung enthielt bei ihrer Einreichung mehr als zehn Patentansprüche.

☐ Nur ein Teil der Anspruchsgebühren wurde innerhalb der vorgeschriebenen Frist entrichtet. Der vorliegende europäische Recherchenbericht wurde für die ersten zehn sowie für jene Patentansprüche erstellt, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

---

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder
Gruppen von Erfindungen, nämlich:

Siehe Ergänzungsblatt B

☐ Alle weiteren Recherchengebühren wurden innerhalb der gesetzten Frist entrichtet. Der vorliegende europäische Recherchenbericht wurde für alle Patentansprüche erstellt.

☒ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

Europäisches
Patentamt

**MANGELNDE EINHEITLICHKEIT
DER ERFINDUNG
ERGÄNZUNGSBLATT B**

Nummer der Anmeldung

EP 06 00 2354

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-23 (C25D17/00)

   Vorrichtung zur elektrolytischen Behandlung von Bandförmigen Behandlungsgut, mit Kontakt- und Transportwalzen

1.1. Ansprüche: 1-12 (+ C25D17/06)

   Vorrichtung, wobei eine Gegenwalze (oder Transportwalze) der Kontaktwalze gegenüber liegt. Die Gegenwalze in Verbindung mit der Kontaktwalze sorgt dafür, dass sich ein kleiner Umschlingungswinkel des Bandes um die Kontaktwalze bildet.

1.2. Ansprüche: 13-23 (+ C25D21/12)

   Vorrichtung, wobei jede Anode von einem individuellen Gleichrichter zur Einstellung einer individuellen Stromdichte gespeist wird, so dass die Stromdichte an die örtlichen Schichtdicken der zu behandelnden Oberfläche angepasst wird.

   ---

Bitte zu beachten dass für alle unter Punkt 1 aufgeführten Erfindungen, obwohl diese nicht unbedingt durch ein gemeinsames erfinderisches Konzept verbunden sind, ohne Mehraufwand der eine zusätzliche Recherchengebühr gerechtfertigt hätte, eine vollständige Recherche durchgeführt werden konnte.

# EP 1 741 806 A1

## ANHANG ZUM EUROPÄISCHEN RECHERCHENBERICHT
## ÜBER DIE EUROPÄISCHE PATENTANMELDUNG NR.

EP 06 00 2354

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-09-2006

| Im Recherchenbericht angeführtes Patentdokument | | Datum der Veröffentlichung | Mitglied(er) der Patentfamilie | | Datum der Veröffentlichung |
|---|---|---|---|---|---|
| US 3264198 | A | 02-08-1966 | KEINE | | |
| WO 9218669 | A | 29-10-1992 | AT | 125001 T | 15-07-1995 |
| DE 4326780 | A1 | 16-02-1995 | KEINE | | |
| US 2742417 | A | 17-04-1956 | KEINE | | |
| WO 9722737 | A | 26-06-1997 | AU | 1351597 A | 14-07-1997 |
| | | | US | 5658441 A | 19-08-1997 |
| GB 191406859 | A | 17-06-1915 | DE | 279043 C | |
| | | | FR | 469917 A | |
| EP 0608616 | A | 03-08-1994 | JP | 6228791 A | 16-08-1994 |
| | | | US | 5441619 A | 15-08-1995 |

EPO FORM P0461

Für nähere Einzelheiten zu diesem Anhang : siehe Amtsblatt des Europäischen Patentamts, Nr.12/82

**EP 1 741 806 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10019713 A1
- EP 0959153 A2
- DE 10342512 B3
- DE 69403926 T2